# EUROPÄISCHE PATENTANMELDUNG

(11) **EP 3 546 959 A1**
(43) Veröffentlichungstag der Anmeldung: **02.10.2019**
(21) Anmeldenummer: 18163969.1
(22) Anmeldetag: 26.03.2018
(51) Int. Cl.: G01R 31/02

(54) **ERMITTELN EINER FUNKTIONALITÄT EINES IN EINER SCHALTUNGSANORDNUNG ANGESCHLOSSENEN ELEKTROLYTKONDENSATORS**

(71) Anmelder: Siemens Aktiengesellschaft, 80333 München (DE)
(72) Erfinder: Schuster, Jürgen, 91463 Dottenheim (DE); Schmidt, Robert, 90522 Oberasbach (DE)

(57) **Zusammenfassung**

Die Erfindung betrifft ein Verfahren zum Ermitteln einer Funktionalität eines in einer Schaltungsanordnung angeschlossenen Elektrolytkondensators, der zum Stützen einer Betriebsgleichspannung während eines bestimmungsgemäßen Betriebs in der Schaltungsanordnung dient, bei dem:
- der Elektrolytkondensator in der Schaltungsanordnung mit einem vorgegebenen Strom beaufschlagt wird,
- eine elektrische Spannung (U₁) am Elektrolytkondensator erfasst wird, und
- die erfasste elektrische Spannung (U₁) zum Ermitteln der Funktionalität des Elektrolytkondensators ausgewertet wird.

## Beschreibung

Die Erfindung betrifft ein Verfahren zum Ermitteln einer Funktionalität eines in einer Schaltungsanordnung angeschlossenen Elektrolytkondensators, der zum Stützen einer Betriebsgleichspannung während eines bestimmungsgemäßen Betriebs in der Schaltungsanordnung dient. Darüber hinaus betrifft die Erfindung auch ein Verfahren zum Prognostizieren einer Betriebsdauer eines in einer Schaltungsanordnung angeschlossenen Elektrolytkondensators, der zum Stützen einer Betriebsgleichspannung während eines bestimmungsgemäßen Betriebs in der Schaltungsanordnung dient. Ferner betrifft die Erfindung eine Einrichtung zum Ermitteln einer Funktionalität eines in einer Schaltungsanordnung angeschlossenen Elektrolytkondensators, der zum Stützen einer Betriebsgleichspannung während eines bestimmungsgemäßen Betriebs in der Schaltungsanordnung dient. Schließlich betrifft die Erfindung auch eine Prognoseeinrichtung zum Prognostizieren einer Betriebsdauer eines in einer Schaltungsanordnung angeschlossenen Elektrolytkondensators, der zum Stützen einer Betriebsgleichspannung während eines bestimmungsgemäßen Betriebs in der Schaltungsanordnung dient.

Schaltungsanordnungen der gattungsgemäßen Art sind dem Grunde nach umfänglich bekannt, sodass es eines gesonderten druckschriftlichen Nachweises hierfür nicht bedarf. Schaltungsanordnungen, insbesondere elektronische Schaltungsanordnungen, gelegentlich auch elektrische oder elektronische Schaltungen genannt, sind Anordnungen von elektrischen beziehungsweise elektronischen, elektromechanischen und/oder dergleichen Bauteilen, die elektrisch leitend gemäß einer vorgegebenen Schaltungsstruktur miteinander verbunden sind, um eine gewünschte Funktionalität bereitstellen zu können. Um die Schaltungsanordnung bestimmungsgemäß betreiben zu können, wird sie mit einer Betriebsspannung beaufschlagt, sodass der Schaltungsanordnung elektrische Energie zur Verfügung steht, um ihre Funktionalität ausführen zu können. Bei vielen Schaltungsanordnungen ist vorgesehen, dass die Betriebsspannung eine Betriebsgleichspannung ist. Dies betrifft insbesondere Schaltungsanordnungen aus elektronischen Bauteilen, wie Transistoren, elektrische Widerstände, elektronische Spulen, elektronische Kondensatoren und/oder dergleichen.

Um die gewünschte Funktionalität der Schaltungsanordnung zuverlässig bereitstellen zu können, ist es erforderlich, dass die Betriebsgleichspannung im bestimmungsgemäßen Betrieb einen vorgegebenen Wert einhält. Zu diesem Zweck sind eine Reihe von Maßnahmen schaltungstechnischer Art möglich, um die Betriebsgleichspannung während des bestimmungsgemäßen Betriebs der Schaltungsanordnung zu stabilisieren, sodass die Betriebsgleichspannung in der Regel innerhalb eines vorgegebenen Toleranzbandes gehalten werden kann.

Eine Möglichkeit, die Betriebsgleichspannung der Schaltungsanordnung zu stabilisieren, nutzt Kondensatoren, insbesondere Elektrolytkondensatoren. Elektrolytkondensatoren werden in der Schaltungsanordnung an geeigneten Stellen der Schaltungsstruktur angeschlossen, sodass sie Energieschwankungen innerhalb der Schaltungsanordnung auszugleichen vermögen, wodurch die Betriebsgleichspannung innerhalb der Schaltungsanordnung weitgehend stabilisiert werden kann.

Ein Elektrolytkondensator ist dem Grunde nach ein Kondensator, der jedoch einen besonderen Aufbau hat, wodurch er eine besonders große elektrische Kapazität bereitzustellen vermag. Dies ist für die bestimmungsgemäße Anwendung in der Schaltungsanordnung, nämlich die Betriebsgleichspannung während des bestimmungsgemäßen Betriebs in der Schaltungsanordnung zu stützen, zweckdienlich. Elektrolytkondensatoren weisen also - bezogen auf ihr Bauvolumen - gegenüber anderen Kondensatorbauarten eine vergleichbar große elektrische Kapazität auf, beispielsweise gegenüber Keramikkondensatoren, Folienkondensatoren oder dergleichen.

Häufig weist der Elektrolytkondensator einen Metallbecher auf, der eine Elektrode des Kondensators bildet. In dem Metallbecher ist ein - in der Regel flüssiger oder fester - Elektrolyt angeordnet, der den Metallbecher kontaktiert. Aufgrund einer chemischen Reaktion bildet sich zwischen dem Elektrolyten und dem Metallbecher eine dünne elektrisch isolierende Schicht, die häufig durch eine Oxidschicht gebildet ist. Dies kann je nach Typ des Elektrolytkondensators durch eine anionische Oxidation, gelegentlich auch Formierung genannt, erreicht werden. Der Elektrolyt ist mittels einer weiteren Elektrode angeschlossen.

Bei den in der Regel verwendeten Bauformen ist der Elektrolytkondensator ein gepoltes elektronisches Bauelement, das lediglich mit einer vorgegebenen Gleichspannung hinsichtlich der Polarität beaufschlagt werden darf. Bei einer Verpolung kann der Elektrolytkondensator beschädigt werden. Häufig bildet der Metallbecher eine Plus-Elektrode und die weitere Elektrode, die den Elektrolyten kontaktiert, eine Minus-Elektrode. Für die Stützung der Betriebsgleichspannung in der Schaltungsanordnung stellt die Tatsache, dass der Elektrolytkondensator üblicherweise ein gepoltes elektronisches Bauelement ist, somit keine Nachteile dar.

Elektrolytkondensatoren sind zum Beispiel verfügbar als Aluminium-Elektrolytkondensatoren, als Tantal-Elektrolytkondensatoren, als Niob-Elektrolytkondensatoren und/oder dergleichen. Es gibt Elektrolytkondensatoren in den unterschiedlichsten Bauformen, beispielsweise als bedrahtetes Bauelement, als SMD(Surface-Mounted Device)-Bauelement oder dergleichen. Durch ihre große elektrische Kapazität eignen sich Elektrolytkondensatoren besonders zum Dämpfen von Impulsbelastungen sowie auch Belastungen bei hohen Frequenzen, zum Glätten von mittels Gleichrichterschaltungen gleichgerichteter elektrischer Spannungen, beispielsweise in Netzteilen, Schaltnetzteilen, Spannungswandlern oder dergleichen. Sie dienen insbesondere zum Stützten von Betriebsspannungen, vorzugsweise Betriebsgleichspannungen, wie sie beispielsweise bei Schaltungsanordnungen auftreten können, die digitale Schaltungsanordnungen umfassen oder aus ihnen gebildet sind. Plötzlich auftretende Lastspitzen können durch Elektrolytkondensatoren abgefangen werden, sodass die Betriebsgleichspannung stabilisiert werden kann.

Gleichwohl unterliegen Elektrolytkondensatoren einer Alterung, die dazu führen kann, dass ihre Funktionalität derart beeinträchtigt werden kann, dass die gewünschte Stützung der Betriebsgleichspannung nicht im gewünschten Umfang mehr erreicht werden kann. Dies kann zu Funktionsstörungen der Schaltungsanordnung insgesamt führen oder sogar zu einem vollständigen Ausfall der Schaltungsanordnung.

Um die Funktionalität eines Elektrolytkondensators, der in einer Schaltungsanordnung angeschlossen ist, ermitteln zu können, kann eine Kapazitätsmessung der Kondensatoren im in der Schaltungsanordnung angeschlossenen Zustand durchgeführt werden. Dies erfordert jedoch einen sehr großen Aufwand und ist deswegen in der Regel nicht praktikabel. Ebenso kann der Elektrolytkondensator auch aus der Schaltungsanordnung ausgebaut und vermessen werden, um seine Funktionalität ermitteln zu können. Dies ist jedoch noch aufwändiger als seine Funktionalität im eingebauten Zustand zu ermitteln, zumal dann auch noch ein Ausbau und ein etwaiger Wiedereinbau erforderlich wären. Darüber hinaus können auch diese Maßnahmen des Aus- und Wiedereinbauens weitere Auswirkungen auf die Alterung der Elektrolytkondensatoren haben.

Es ist festzustellen, dass die Alterung der Kondensatoren und damit auch ihre Funktionalität nicht unmittelbar mit der Alterung der Schaltungsanordnung, in der sie angeschlossen sind, zusammenzuhängen brauchen. Die Alterung der Elektrolytkondensatoren kann von einer Reihe von Faktoren, insbesondere von Betriebsbedingungen abhängig sein.

Der Erfindung liegt die Aufgabe zugrunde, die Funktionalität eines Elektrolytkondensators verbessert ermitteln zu können.

Als Lösung werden mit der Erfindung Verfahren und Einrichtungen gemäß den unabhängigen Ansprüchen vorgeschlagen.

Vorteilhafte Weiterbildungen ergeben sich durch Merkmale der abhängigen Ansprüche.

Bezüglich eines gattungsgemäßen Verfahrens zum Ermitteln einer Funktionalität eines in einer Schaltungsanordnung angeschlossenen Elektrolytkondensators wird insbesondere vorgeschlagen, dass der Elektrolytkondensator in der Schaltungsanordnung mit einem vorgegebenen Strom beaufschlagt wird, eine elektrische Spannung am Elektrolytkondensator erfasst wird, und die erfasste elektrische Spannung zum Ermitteln der Funktionalität des Elektrolytkondensators ausgewertet wird.

Bezüglich eines gattungsgemäßen Verfahrens zum Prognostizieren einer Betriebsdauer einer in einer Schaltungsanordnung angeschlossenen Elektrolytkondensators wird insbesondere vorgeschlagen, dass für eine Mehrzahl von gleichartigen Schaltungsanordnungen jeweils das Verfahren zum Ermitteln der Funktionalität eines in einer Schaltungsanordnung angeschlossenen Elektrolytkondensators gemäß der Erfindung durchgeführt wird, und die mit dem erfindungsgemäßen Verfahren ermittelten Daten zum Ermitteln der prognostizierten Betriebsdauer statistisch ausgewertet werden.

Bezüglich einer gattungsgemäßen Einrichtung zum Ermitteln einer Funktionalität eines in einer Schaltungsanordnung angeschlossenen Elektrolytkondensators wird insbesondere vorgeschlagen, dass die Einrichtung ausgebildet ist, das Beaufschlagen eines Elektrolytkondensators mit einem vorgegebenen Strom in der Schaltungsanordnung zu erfassen, eine elektrische Spannung am Elektrolytkondensator zu erfassen, und die erfasste elektrische Spannung zum Ermitteln der Funktionalität des Elektrolytkondensators auszuwerten.

Schließlich wird bezüglich einer gattungsgemäßen Prognoseeinrichtung insbesondere vorgeschlagen, dass mittels der Einrichtung der Erfindung für eine Mehrzahl von gleichartigen Schaltungsanordnungen jeweils eine Funktionalität eines in den jeweiligen Schaltungsanordnungen angeschlossenen Elektrolytkondensators zu ermitteln, und die mit der erfindungsgemäßen Einrichtung ermittelten Daten zum Ermitteln der prognostizierten Betriebsdauer statistisch auszuwerten.

Die Erfindung ermöglicht es somit, ohne Eingriff in die Schaltungsanordnung als solche, beispielsweise indem aufwändige Messsensorik in der Schaltungsanordnung vorgesehen wird oder auch der Elektrolytkondensator ausgebaut und wieder eingebaut wird, die Funktionalität des Elektrolytkondensators zuverlässig zu ermitteln. Diesem Zweck dient der vorgegebene Strom, der es erlaubt, einen Lastwechsel am Elektrolytkondensator durchzuführen und die Auswirkungen des Lastwechsels zu erfassen, indem die elektrische Spannung am Elektrolytkondensator erfasst wird. Dies erlaubt es, durch das Auswerten eine Einschätzung bezüglich der Restkapazität des Elektrolytkondensators zu ermitteln und somit auch eine Aussage darüber zu erhalten, ob ein Auswechseln beziehungsweise Warten des Elektrolytkondensators erforderlich ist beziehungsweise die Schaltungsanordnung beziehungsweise der Teil der Schaltungsanordnung, der funktionell mit dem Elektrolytkondensator gekoppelt ist, auszutauschen.

Dabei erweist es sich als Vorteil, dass genau festgestellt werden kann, ab wann die elektrische Spannung aufgrund einer Kapazitätsreduzierung des Elektrolytkondensators ein problematisches Verhalten der Schaltungsanordnung zur Folge hat, beispielsweise eine Schwingneigung der Betriebsgleichspannung bei dem Lastwechsel oder dergleichen.

Die Funktionalität des Elektrolytkondensators bezieht sich insbesondere auf seine aktuelle Kapazität, seine aktuelle Spannungsbelastbarkeit, seine Strombelastbarkeit und/oder dergleichen. Darüber hinaus kann sie sich natürlich auch auf einen Alterungszustand, einen Betriebszustand und/oder dergleichen beziehen.

Die Erfindung basiert dabei auf der Erkenntnis, das unter anderem eine Verdunstung des Elektrolyten des Elektrolytkondensators und eine damit einhergehende Diffusion von Gasen aus dem Elektrolytkondensator heraus temperaturabhängig ist und dazu führen kann, dass die Funktionalität des Elektrolytkondensators eingeschränkt ist, insbesondere der Elektrolytkondensator auch ausfallen kann.

Von Herstellern von Elektrolytkondensatoren durchgeführte Lebensdauerprüfungen werden in der Regel nur bei einer vorgegebenen oberen Grenztemperatur durchgeführt. Ein Betrieb der Elektrolytkondensatoren in der Schaltungsanordnung erfolgt jedoch üblicherweise bei einer deutlich kleineren Temperatur, was im Übrigen eine reduzierte Diffusionsrate in Bezug auf den Elektrolyten zur Folge hat, was sich in der Folge als eine längere Lebensdauer zeigt, als durch die Herstellerangabe angegeben.

Darüber hinaus wird berücksichtigt, dass die Lebensdauer beziehungsweise die Alterung des Elektrolytkondensators auch von weiteren Bedingungen, insbesondere einer konkreten Lastsituation abhängig sein kann. Die Verlängerung der Lebensdauer beziehungsweise die Reduzierung der Alterung in Bezug auf die auf die obere Grenztemperatur ermittelten Werte wird in Datenblättern zu Elektrolytkondensatoren von vielen Herstellern durch die Arrhenius-Regel (auch 10-Draht-Regel oder RGT-Regel genannt) erfasst. Gemäß der Arrhenius-Regel kann eine Verdoppelung der Lebensdauer beziehungsweise eine Halbierung der Alterung erreicht werden, wenn eine Betriebstemperatur um 10°C reduziert wird. Dabei werden allerdings dynamische Spannungsänderungen nicht berücksichtigt. Hieraus kann zwar eine grobe Abschätzung für die Lebenserwartung beziehungsweise die Alterung des konkreten Elektrolytkondensators erreicht werden, jedoch eignet sich dies nicht für eine präzise Vorhersage. Da Elektrolytkondensatoren in Schaltungsanordnungen unterschiedlichster Art weit verbreitet sind und die Zuverlässigkeit der Schaltungsanordnung wesentlich beeinflussen können, ist die Alterung des Elektrolytkondensators beziehungsweise seine Lebensdauer auch für die Schaltungsanordnung insgesamt relevant.

Mit der Erfindung kann somit auch das Problem erfasst werden, dass bei Elektrolytkondensatoren häufig auch ein graduelles Versagen mit der Zeit auftreten kann, wobei das Versagen oftmals über einen langen Zeitraum nicht bemerkt zu werden braucht. Die Stabilität der Schaltungsanordnung beziehungsweise des Produktes, welches die Schaltungsanordnung umfasst, zeigt sich zunehmend schlechter, zum Beispiel dadurch, dass bei einem Personal Computer vermehrt Systemabstürze auftreten. Nach Erreichen eines kritischen Wertes der Funktionalität des Elektrolytkondensators kann das gesamte Produkt für einen Kunden unbrauchbar werden und somit einen vollständigen Tausch erfordern. Bei einer etwaig nachgelagerten Reparatur kann zwar oftmals ein Fehler auf eine Baugruppe der Schaltungsanordnung eingegrenzt werden, zum Beispiel bei einem Personal Computer ein Main Board oder dergleichen, sodass letztlich lediglich diese Komponente getauscht zu werden braucht, jedoch ist auch dies aufwändig und teuer.

Ein alternativer Präventivtausch von Elektrolytkondensatoren in der Schaltungsanordnung erweist sich ebenfalls als wenig zweckmäßig, zumal keine exakten Angaben in Bezug auf die Alterung beziehungsweise die Lebenserwartung in der Schaltungsanordnung verfügbar sind. In der Praxis erweist sich diese Maßnahme im Übrigen auch aufgrund des hohen Aufwands als kaum realisierbar.

Die Erfindung basiert auf dem Gedanken, einen Lastwechsel am Elektrolytkondensator auszuwerten, um seine Funktionalität ermitteln zu können. Zu diesem Zweck wird die elektrische Spannung am zu untersuchenden Elektrolytkondensator erfasst und ausgewertet. Der Lastwechsel wird durch den vorgegebenen Strom hervorgerufen, mit dem der Elektrolytkondensator beaufschlagt wird. Der vorgegebene Strom kann ein elektrischer Strom sein, der im bestimmungsgemäßen Betrieb der Schaltungsanordnung ohnedies zumindest zu vorgegebenen Zeitpunkten oder in wiederkehrender Abfolge oder dergleichen auftritt. Der vorgegebene Strom wird hierbei schaltungsintern bereitgestellt, das heißt, von der Schaltungsanordnung selbst, vorzugsweise während des bestimmungsgenäßen Betriebs erzeugt. Zu diesem Zweck kann vorgesehen sein, dass ein Auftreten eines bestimmten Betriebszustands genutzt ermittelt wird, welches den vorgegebenen Strom zur Folge haben kann. Es kann auch vorgesehen sein, dass die Schaltungsanordnung hierfür einen vorgegebenen Betriebszustand einnimmt. Das Einnehmen dieses Betriebszustands kann zu vorgebbaren Zeitpunkten und/oder durch ein geeignetes Prüfsignal als Steuersignal erfolgen, welches auf die Schaltungsanordnung einwirkt. Es kann natürlich auch ein vorgegebener Strom mittels einer geeigneten Prüfstromschaltung auf den Elektrolytkondensator aufgegeben werden. Der vorgegebene Strom wird hierbei dann schaltungsextern bereitgestellt. Dabei ist jedoch zu beachten, dass die Funktionalität der Schaltungsanordnung als solche nicht dauerhaft beeinträchtigt werden darf oder beschädigt wird.

Durch das Auswerten der erfassten elektrischen Spannung kann dann die Funktionalität des Elektrolytkondensators ermittelt werden, um abhängig von der ermittelten Funktionalität ein Meldesignal auszugeben. Anhand des Meldesignals kann die Funktionalität des Elektrolytkondensators ermittelt werden. Das Meldesignal kann zum Beispiel ein digitales, insbesondere binäres Signal sein, mit welchem angezeigt werden kann, ob die Funktionalität des Elektrolytkondensators für seinen bestimmungsgemäßen Betrieb in der Schaltungsanordnung noch ausreicht. Es kann jedoch auch ein Meldesignal sein, welches zum Beispiel eine elektrische Kapazität des Elektrolytkondensators angibt, die er aktuell noch hat.

Insbesondere bei einer graduellen Verschlechterung der Funktionalität des Elektrolytkondensators kann vorgesehen sein, das durch Maßnahmen in der Schaltungsanordnung die Beanspruchung des Elektrolytkondensators reduziert wird, um insgesamt die Funktionalität der Schaltungsanordnung weiter zuverlässig gewährleisten zu können.

Die Erfindung hat den Vorteil, dass schaltungsanordnungsspezifisch die Funktionalität des Elektrolytkondensators ermittelt werden kann. Dabei ist es möglich, für eine jeweilige Schaltungsanordnung zum Beispiel durch Versuche, beispielsweise auf einer Anwendungsebene oder dergleichen, zu ermitteln, bis zu welchem Strom eine bestimmungsgemäße Funktionalität der Schaltungsanordnung noch gewährleistet ist. Die Messung des durch den vorgegebenen Strom hervorgerufenen Lastwechsels beziehungsweise des Lastwechsels kann zum Beispiel in einem Entwicklungsprozess in einem Labor beziehungsweise in einem geeignet ausgerüsteten Prüffeld erfolgen, zum Beispiel unter Nutzung eines Oszilloskops, oder auch kontinuierlich erfolgen, beispielsweise indem durch Integration in eine geeignete integrierte Schaltung eine Überwachung automatisiert und/oder im fortlaufenden Betrieb erfolgen kann.

Die Erfindung nutzt dabei die Erkenntnis, dass insbesondere mit nachlassender Kapazität des Elektrolytkondensators zunehmend auch Schwingungen der Betriebsgleichspannung auftreten können, häufig als gedämpfte Schwingung, insbesondere bei dynamischen Lastwechseln im bestimmungsgemäßen Betrieb der Schaltungsanordnung. Es wurde unter anderem festgestellt, dass insbesondere bei einem Sprung eines Stroms die Sprungantwort von der aktuell verfügbaren elektrischen Kapazität des Elektrolytkondensators abhängt. Verringert sich die elektrische Kapazität des Elektrolytkondensators, kann sich das Verhalten der erfassten elektrischen Spannung bei der gleichen Stromantwort von einem gewünschten Kriechfall in eine ungewünschte gedämpfte Schwingung verändern, beispielsweise wenn eine entsprechen DC/DC-Regelung vorliegt.

Eine derartige Regelung kann insbesondere vierstufig aufgebaut sein.

Eine erste Stufe kann durch einen oder mehrere Plattenkondensatoren gebildet sein, die auf einer Trägerplatte, insbesondere Leiterplatte ausgebildet sind, die Bauteile der Schaltungsanordnung trägt und elektrisch koppelt. Hierdurch kann eine sehr reaktionsschnelle Kapazität erreicht werden, wobei jedoch lediglich sehr kleine Kapazitätswerte realisiert werden können. Der Plattenkondensator kann dem Grunde nach durch ein separates Bauteil gebildet sein. Häufiger wird der Plattenkondensator jedoch zumindest teilweise auch durch zwei oder mehrere elektrisch leitfähige Schichten eines Baugruppenträgers, beispielsweise einer Leiterplatte oder dergleichen, gebildet sein, die mittels eines elektrischen Feldes untereinander gekoppelt sind. Der Plattenkondensator braucht also nicht zwingend ein separat handhabbares Bauteil zu sein.

Gemäß einer zweiten Stufe können Keramikkondensatoren, insbesondere SMD-Keramikkondensatoren vorgesehen sein, mittels denen jedoch nur eine kleine Kapazität bereitgestellt werden kann. Gleichwohl kann mit diesen Kondensatoren immer noch eine schnelle Reaktionsgeschwindigkeit realisiert werden.

Eine dritte Stufe der Regelung sieht die Elektrolytkondensatoren vor, die eine große Kapazität bei einer normalen Reaktionsgeschwindigkeit bereitzustellen vermögen, jedoch bezüglich der Regelung vergleichsweise langsam im Vergleich zu den anderen Kondensatoren sind.

Eine vierte Stufe der Regelung kann dadurch vorgesehen sein, dass eine Betriebsgleichspannungsquelle, beispielsweise ein DC/DC-Wandler, ein Netzteil oder dergleichen, vorgesehen ist, die eine Spannungsregelungsfunktion für die Betriebsgleichspannung bereitstellt. Im Vergleich zu der Reaktionsgeschwindigkeit der Kondensatoren kann hier jedoch nur eine langsame Reaktionsgeschwindigkeit realisiert werden.

Kleine Stromänderungen in der Schaltungsanordnung können zunächst vom Plattenkondensator und dann vom Keramikkondensator abgefangen werden. Bei einer größeren Stromänderung tritt die Funktionalität des Elektrolytkondensators hinzu, um zum Beispiel einen Strom bereitzustellen, bis die Regelung aufgrund der Betriebsgleichspannungsquelle ein Nachregeln realisieren kann. Das Zusammenspiel der einzelnen Komponenten ist dabei in der Regel so ausgelegt, dass nach Möglichkeit in keinem bestimmungsgemäßen Betriebsfalls eine Schwingneigung insbesondere bezüglich der Betriebsgleichspannung entsteht.

Nimmt nun aufgrund der Alterung die tatsächliche elektrische Kapazität des Elektrolytkondensators ab, kann irgendwann ein Punkt erreicht sein, bei dem der Elektrolytkondensator nicht mehr genug Strom bereitstellen kann, sodass etwaige Stromanforderungen durch die Betriebsgleichspannungsquelle bereitgestellt werden müssen. Aufgrund der vergleichsweise langsamen Regelungsgeschwindigkeit kann dies jedoch zu einem Schwingereignis führen.

Die Funktionalität des Elektrolytkondensators kann nun anhand der folgenden Überlegungen ermittelt werden. Ist die Schaltungsanordnung neu dimensioniert und liegt kein Dimensionierungsfehler vor, beispielsweise indem ein Kondensator zu klein bemessen ist oder dergleichen, sollte es im bestimmungsgemäßen Betrieb kein Schwingereignis in Bezug auf das Regeln der Betriebsgleichspannung geben. Tritt ein Lastsprung auf, sollte dies nach Art eines Kriechfalls mit einer entsprechenden Anfangsamplitude in der erfassten elektrischen Spannung auffallen. Liegen Messwerte bezüglich der elektrischen Spannung und des Stromsprungs vor, kann die Höhe einer Spannungsamplitude einer Höhe des Stromsprungs zugeordnet werden. Diese Größen stehen über die tatsächlich bereitgestellte elektrisch Kapazität des Elektrolytkondensators in Verbindung.

Ist der Elektrolytkondensator dagegen gealtert, sodass er insbesondere nicht mehr die ursprünglich angegebene Bemessungskapazität sondern lediglich nur noch einen Teil hiervon bereitzustellen vermag, so wird sich die Amplitude des Kriechfalls bei abnehmender elektrischer Kapazität immer weiter erhöhen, bis der aperiodische Grenzfall erreicht ist. Sinkt die Kapazität darüber hinaus weiter ab, wird sich eine gedämpfte Schwingung der Betriebsgleichspannung einstellen.

Mit zunehmender Alterung beziehungsweise Reduzierung der elektrischen Kapazität des Elektrolytkondensators wird auch die Amplitude dieser Schwingung immer größer, wodurch immer mehr Regeleinriffe der Betriebsgleichspannungsquelle erforderlich sind, um die hierdurch verursachte Störgröße ausgleichen zu können. Dadurch wird die Anzahl der Schwingungen ebenfalls größer.

Ist es in der Schaltungsanordnung möglich, den entsprechenden Strom als vorgegebenen Strom messen zu können, können die folgenden Fälle unterschieden werden:
Ein erster Fall ist der Kriechfall, bei dem der elektrische Strom beziehungsweise der vorgegebenen Strom und die elektrische Spannung gemessen werden und die Höhe des vorgegebenen Stroms beziehungsweise eines etwaigen Stromsprungs der Höhe der Amplitude der erfassten elektrischen Spannung zugeordnet werden kann. Bei alternden Elektrolytkondensatoren nimmt diese Amplitude immer mehr zu.

Ein zweiter Fall ist der Schwingfall, bei dem ebenfalls der elektrische Strom beziehungsweise der vorgegebene Strom und die elektrische Spannung gemessen werden und die Höhe des vorgegebenen Stroms beziehungsweise eines etwaigen Stromsprungs der Höhe der Amplitude der erfassten elektrischen Spannung zugewiesen werden können. Bei alternden Elektrolytkondensatoren nimmt auch diese Amplitude immer weiter zu.

Ein dritter Fall ist ein weiterer Schwingfall, bei dem ebenfalls der elektrische Strom beziehungsweise der vorgegebene Strom und die elektrische Spannung gemessen werden. Hier wird die Anzahl der Schwingungen beziehungsweise die Zeitdauer des Schwingereignisses zur Ausregelung erfasst. Diese erhöht sich für einen bestimmten vorgegebenen Strom beziehungsweise etwaigen Stromsprung mit Zunahme der Alterung des Elektrolytkondensators.

Ein weiterer vierter Fall betrifft ebenfalls einen Schwingfall, bei dem der elektrische Strom beziehungsweise der vorgegebene Strom und die elektrische Spannung gemessen werden. Bei einem alternden Elektrolytkondensator tritt diese Schwingung bei immer niedrigeren Prüfströmen beziehungsweise etwaigen Stromsprüngen auf.

Hiervon unterscheidet sich der Fall, bei dem nur die elektrische Spannung gemessen werden kann.

Wenn nur die elektrische Spannung am Elektrolytkondensator gemessen werden kann, können insbesondere Schwingereignisse der erfassten elektrischen Spannung erfasst werden, die aufgrund des vorgegebenen Stroms beziehungsweise eines etwaigen Stromsprungs auftreten können, wobei die Anzahl der Schwingereignisse mit zunehmender Alterung des Elektrolytkondensators zunimmt. Darüber hinaus kann auch die Anzahl der Schwingungen beziehungsweise die Zeitendauer der Schwingung bis zum Abklingen beziehungsweise bis sie als Störgröße ausgeregelt sind, mit zunehmender Alterung des Elektrolytkondensators zunehmen.

Der vorgegebene Strom ist der elektrische Strom, der für die erfindungsgemäße Verfahrensführung zum Ermitteln der Funktionalität des Elektrolytkondensators herangezogen wird. Der vorgegebene Strom kann durch eine elektrische oder elektronische Prüfstromschaltung erzeugt und auf den Elektrolytkondensator gegeben werden. Es kann jedoch auch vorgesehen sein, dass die Schaltungsanordnung im bestimmungsgemäßen Betrieb überwacht wird und ein geeigneter Lastwechsel ermittelt wird, der als vorgegebener Strom zugrundegelegt wird. Diese Ausgestaltung hat den Vorteil, dass keine separaten Bauteile und Baugruppen benötigt werden, um den vorgegebenen Strom bereitstellen zu können.

Der vorgegebene Strom kann beispielsweise ein Stromsprung sein. Die Amplitude des Stromsprungs kann sowohl positiv als auch negativ sein. Darüber hinaus kann der vorgegebene Strom auch durch einen Stromimpuls gebildet sein, insbesondere ein Stromimpuls, der eine vorgebbare Ladungsmenge und/oder eine vorgebbare Impulsdauer umfasst. Die Ladungsmenge kann an den zu prüfenden Elektrolytkondensator, insbesondere seiner Bemessungskapazität angepasst sein. Sie kann aber auch an einen Auslegungsfall für den bestimmungsgemäßen Betrieb angepasst sein.

Als Spannungssensor kann eine übliche Schaltung zum Erfassen einer elektrischen Spannung vorgesehen sein. Der Spannungssensor ist vorzugsweise dazu ausgebildet, hochdynamische Spannungsänderungen erfassen zu können, um auf diese Weise auch hochfrequente oder kurzzeitige Spannungsänderungen zuverlässig erfassen zu können. Der Spannungssensor kann elektrische Sensorkontakte aufweisen, die es erlauben, Anschlusskontakte des zu prüfenden Elektrolytkondensators zu kontaktieren. Der Spannungssensor kann darüber hinaus auch eine galvanische Trennung umfassen, sodass auch während des bestimmungsgemäßen Betriebs der Schaltungsanordnung die elektrische Spannung am Elektrolytkondensator sicher und zuverlässig erfasst werden kann, vorzugsweise ohne die bestimmungsgemäße Funktionalität der Schaltungsanordnung zu beeinträchtigen. Natürlich kann der Spannungssensor auch von der Schaltungsanordnung selbst umfasst sein.

Die erfasste elektrische Spannung wird zum Ermitteln der Funktionalität des Elektrolytkondensators ausgewertet. Die Funktionalität des Elektrolytkondensators betrifft in der Regel seine aktuell verfügbare elektrische Kapazität, die einem gewissen Alterungszustand des Elektrolytkondensators zugeordnet werden kann. Darüber hinaus können natürlich auch noch weitere Größen des Elektrolytkondensators erfasst und ausgewertet werden, um das Ermitteln der Funktionalität des Elektrolytkondensators weiter zu verbessern, beispielsweise einen Innendruck des Elektrolytkondensators, eine Temperatur des Elektrolytkondensators im bestimmungsgemäßen Betrieb und/oder dergleichen.

Durch das Auswerten kann die aktuelle Funktionalität des Elektrolytkondensators ermittelt werden, indem aus der erfassten Spannung und gegebenenfalls weiteren Parametern die entsprechenden Zustandsgrößen des Elektrolytkondensators, insbesondere seine aktuelle verfügbare elektrische Kapazität, ermittelt werden. Hierzu können Vergleichsdaten herangezogen werden. Diese können zum Beispiel unter vorgegebenen Betriebsbedingungen in einem Laborbetrieb oder dergleichen ermittelt werden.

Abhängig von der ermittelten Funktionalität wird ein Meldesignal ausgegeben. Das Meldesignal kann ein elektrisches Signal oder dergleichen sein. Vorzugsweise ist es ein digitales oder auch ein analoges Signal. Das Meldesignal kann dazu dienen, anzuzeigen, ob der Elektrolytkondensator die bestimmungsgemäße Funktion noch ausreichend erfüllt oder nicht. Es kann aber auch mehr als zwei Werte wie gut oder schlecht umfassen, beispielsweise einen aktuellen Kapazitätswert oder dergleichen angeben. Dieses Signal kann dann dazu benutzt werden, weitere Maßnahmen zu treffen, beispielsweise eine Wartung des Elektrolytkondensators, einen Austausch der gesamten Schaltungsanordnung und/oder dergleichen.

Die erfindungsgemäße Einrichtung zum Ermitteln einer Funktionalität eines in einer Schaltungsanordnung angeschlossenen Elektrolytkondensators kann ebenfalls durch eine elektronische Schaltung oder dergleichen gebildet sein. Dem Grunde nach kann die Einrichtung jedoch auch von der Schaltungsanordnung selbst umfasst sein, deren Elektrolytkondensator hinsichtlich seiner Funktionalität geprüft werden soll. Insofern kann die Schaltungsanordnung natürlich auch durch eine integrierte Schaltung oder eine sonstige elektronische Baugruppe gebildet sein. Sie kann aber auch als eine separat handhabbare Baugruppe ausgebildet sein. Besonders vorteilhaft ist die Einrichtung einer tragbaren Baugruppe, die für ihren bestimmungsgemäßen Betrieb einen eigenen elektrischen Energiespeicher in Form eines Akkumulators oder einer Batterie umfasst, sodass sie einfach handhabbar ist.

Es wird ferner vorgeschlagen, dass das Auswerten ein Ermitteln eines Auftretens oder eines Verstärkens wenigstens eines Schwingereignisses bei der erfassten elektrischen Schwingung umfasst. Tritt das Schwingereignis erstmals auf, können hieraus Rückschlüsse auf die aktuell verfügbare elektrische Kapazität des Elektrolytkondensators geschlossen werden. Das gleiche gilt dem Grunde nach auch für den Fall, dass ein bekanntes Schwingereignis bei der erfassten elektrischen Spannung gegenüber dem bekannten Schwingereignis verstärkt ist. Auch hieraus können entsprechende Rückschlüsse auf die tatsächliche aktuelle elektrische Kapazität des Elektrolytkondensators erfolgen. Das Auswerten kann hierdurch weiter verbessert werden.

Weiterhin wird vorgeschlagen, dass das Auswerten ein Ermitteln einer Anzahl der Schwingereignisse umfasst. Die Anzahl der Schwingereignisse kann nämlich ein Maß dafür sein, welchen Alterungszustand der Elektrolytkondensator hat, das heißt, welche Funktionalität der Elektrolytkondensator noch bereitzustellen vermag. Dabei kann die Anzahl der Schwingereignisse mit zunehmender Alterung beziehungsweise abnehmender elektrischer Kapazität zunehmen.

Gemäß einer Weiterbildung wird vorgeschlagen, dass das Auswerten ein Ermitteln einer Zeitdauer des wenigstens einen Schwingereignisses umfasst. Diese Weiterbildung geht davon aus, dass es sich bei dem Schwingereignis um eine gedämpfte Schwingung handelt, sodass deren Zeitdauer bis zum Abklingen ermittelt werden kann. Alternativ oder ergänzend können natürlich auch die Anzahl der einzelnen Schwingungen des Schwingereignisses ermittelt werden, um das Auswerten zu verbessern. Auch hieraus können Rückschlüsse auf die aktuell verfügbare elektrische Kapazität des Elektrolytkondensators erhalten werden.

Besonders vorteilhaft erweist es sich, wenn der Elektrolytkondensator mit einem Stromsprung oder einem Stromimpuls als vorgegebenen Strom beaufschlagt wird. Der Stromsprung beziehungsweise der Stromimpuls hat vorzugsweise eine vorgegebene Flankensteilheit, sodass die gewünschten Parameter des Elektrolytkondensators, insbesondere seine aktuell verfügbare elektrische Kapazität, hieraus ermittelt werden können. Insbesondere bezüglich des Stromimpulses kann vorgesehen sein, dass dieser eine vorgegebene Ladungsmenge umfasst, die innerhalb einer vorgegebenen Zeit zur Verfügung gestellt wird. Dadurch kann einen spezifische Reaktion des Elektrolytkondensators erreicht werden, die es erlaubt, zuverlässig die Funktionalität des Elektrolytkondensators, insbesondere seiner aktuell verfügbaren elektrischen Kapazität, zu ermitteln.

Besonders vorteilhaft erweist es sich, wenn die Schaltungsanordnung zum Beaufschlagen des Elektrolytkondensators mit dem vorgegebenen Strom in geeigneter Weise gesteuert wird. Zu diesem Zweck kann vorgesehen sein, dass die Schaltungsanordnung mittels eines geeigneten Prüfsignals gesteuert werden kann, um den Kondensator mit dem vorgegebenen Strom zu beaufschlagen. Das Prüfsignal kann zum Beispiel als externes Signal auf die Schaltungsanordnung aufgegeben werden. Darüber hinaus kann natürlich vorgesehen sein, dass ein vorgegebener Strom vorgegeben wird und, sobald die Schaltungsanordnung einen entsprechenden vorgegebenen Strom aufgrund ihres bestimmungsgemäßen Betriebs auf den Elektrolytkondensator gibt, ein entsprechendes Prüfsignal an die Einrichtung der Erfindung übermittelt wird, sodass diese die zugehörige elektrische Spannung erfassen kann. Dadurch ist zugleich auch eine Zuordnung zwischen dem vorgegebenen Strom und der erfassten elektrischen Spannung auf einfache Weise möglich. Das Steuern der Schaltungsanordnung kann also auch lediglich ihren bestimmungsgemäßen Betrieb umfassen.

Gemäß einer Weiterbildung wird vorgeschlagen, dass zum Auswerten ein Vergrößern eines Rippels der erfassten elektrischen Spannung berücksichtigt wird. Diese Weiterbildung berücksichtigt, dass im bestimmungsgemäßen Betrieb des Elektrolytkondensators aufgrund der Beaufschlagung durch die Schaltungsanordnung ein Spannungsrippel am Elektrolytkondensator vorliegt, der von den jeweiligen Strömen durch den Elektrolytkondensator abhängig ist. Vergrößert sich der Rippel der erfassen elektrischen Spannung, kann hierdurch ergänzend auf das Altern des Elektrolytkondensators beziehungsweise auf seine Funktionalität geschlossen werden. Dies kann ergänzend beim Auswerten berücksichtigt werden. Hierzu ist die elektrische Spannung vorzugsweise möglichst kontinuierlich zu erfassen. Dadurch eignet sich diese Weiterbildung natürlich insbesondere auch für den Fall, dass die Erfindung bereits in die Schaltungsanordnung selbst integriert ist. Das Auswerten kann hierdurch weiter verbessert werden.

Vorzugsweise wird abhängig von dem Auswerten eine aktuelle Kapazität des Elektrolytkondensators ermittelt. Das Auswerten kann neben unter anderem statistischen Methoden beispielsweise auch Herstellerangaben oder dergleichen mit umfassen, sodass die aktuelle Kapazität des Elektrolytkondensators mit großer Genauigkeit ermittelt werden kann. Diese kann dann mit einer Soll-Kapazität des Elektrolytkondensators verglichen werden, um festzustellen, ob eine Wartung bezüglich des Elektrolytkondensators erforderlich ist. Die Soll-Kapazität ist vorzugsweise ein Wert, der erforderlich ist, damit die Schaltungsanordnung in ihrem bestimmungsgemäßen Betrieb im Wesentlichen nicht gestört ist.

Ferner wird vorgeschlagen, dass der vorgegebene Strom mittels eines Stromsensors erfasst wird und das Auswerten ergänzend den erfassten vorgegebenen Strom berücksichtigt. Dadurch kann das Auswerten insgesamt nochmals verbessert werden, weil nun der tatsächlich den Elektrolytkondensator durchströmende Strom zur Verfügung steht. Dies erlaubt es, ein hochgenaues Ergebnis bezüglich der Funktionalität des Elektrolytkondensators, insbesondere seiner elektrischen Kapazität, zu erreichen.

Weiterhin wird vorgeschlagen, dass das Auswerten durch das Beaufschlagen des Elektrolytkondensators mit dem vorgegebenen Strom ausgelöst wird. Das Auswerten braucht also nicht kontinuierlich durchgeführt zu werden. Das Auswerten braucht lediglich dann durchgeführt zu werden, wenn der Elektrolytkondensator mit dem vorgegebenen Strom beaufschlagt wird. Dadurch kann das Auswerten insgesamt günstiger, beispielsweise hinsichtlich des Energieverbrauchs sparsamer realisiert werden. Darüber hinaus kann Verarbeitungskapazität bezüglich des Auswertens anderweitig genutzt werden.

Die Erfindung eignet sich aber nicht nur dazu, die Funktionalität eines einzelnen, vorgegebenen Kondensators ermitteln zu können. Vielmehr besteht die Möglichkeit, die Lebensdauer beziehungsweise Betriebsdauer des in der Schaltungsanordnung angeschlossenen Elektrolytkondensators zu prognostizieren. Zu diesem Zweck wird gemäß der Erfindung für eine Mehrzahl von gleichartigen Schaltungsanordnungen jeweils das Verfahren nach der Erfindung durchgeführt und die mit dem Verfahren der Erfindung ermittelten Daten zum Ermitteln der prognostizierten Betriebsdauer statistisch ausgewertet. Dadurch werden eine Vielzahl von Daten bezüglich des Elektrolytkondensators an der jeweiligen Position in der Schaltungsanordnung ermittelt.

Gleichartige Schaltungsanordnungen meint dabei im Wesentlichen identische Schaltungsanordnungen, zumindest in Bezug auf die Funktionalität des Elektrolytkondensators. Dadurch, dass für die Mehrzahl der Schaltungsanordnungen bezüglich eines jeweiligen Elektrolytkondensators beziehungsweise eines Elektrolytkondensators an einer jeweiligen Stelle der Schaltungsanordnung eine Vielzahl von Daten in dieser spezifischen Schaltungsanordnung zur Verfügung gestellt werden können, beispielsweise nach Art von Big Data, kann eine Prognose bezüglich der Funktionalität des Elektrolytkondensators in der Schaltungsanordnung mittels statistischer Auswertungsmethoden erreicht werden. Dabei können jeweilige Alterungszustände von Elektrolytkondensatoren aus entsprechenden Schaltungsanordnungen hinzugezogen werden, um zum Beispiel unter Nutzung einer Mittelwertbildung, ermitteln von Standardabweichungen und/oder dergleichen, unter Berücksichtigung von aktuellen Parametern eines Elektrolytkondensators einer jeweiligen Schaltungsanordnung die entsprechende Prognose für die Alterung beziehungsweise die Betriebsdauer zu ermitteln. Diese Daten können daher nicht nur dazu dienen, eine Schaltungsanordnung entsprechend zu konstruieren, sondern sie können darüber hinaus auch dazu dienen, Wartungsintervalle für Schaltungsanordnungen festzulegen und darüber hinaus auch dazu, was für Wartungspositionen bei einem jeweiligen Wartungsschritt durchzuführen sind.

Dieses Verfahren kann mit einer geeigneten Prognoseeinrichtung gemäß der Erfindung ausgeführt werden, wie sie eingangs bereits angegeben wurde. Die Prognoseeinrichtung kann ebenso wie die Einrichtung zur Durchführen des Verfahrens der Erfindung eine separat handhabbare Einheit sein, beispielsweise ein Prüfstand oder dergleichen. Sie kann aber zumindest teilweise auch in die jeweiligen Schaltungsanordnungen integriert sein, sodass insbesondere das Erfassen der elektrischen Spannung am Elektrolytkondensator zumindest teilweise in die Schaltungsanordnung integriert sein kann. Darüber hinaus kann natürlich vorgesehen sein, dass die Prognoseeinrichtung eine Steuereinheit aufweist, die mit der Schaltungsanordnung kommunikationstechnisch gekoppelt werden kann, um die Schaltungsanordnung in einen oder mehrere gewünschte Betriebszustände zu bringen, die es erlauben, die gewünschte Funktionalität bereitzustellen.

Es wird bezüglich des Prognostizierens ferner vorgeschlagen, dass für einen in einer vorgegebenen Schaltungsanordnung angeschlossenen Elektrolytkondensator eine Restbetriebsdauer ermittelt wird, indem für die vorgegebene Schaltungsanordnung das Verfahren zum Ermitteln der Funktionalität des Elektrolytkondensators gemäß der Erfindung durchgeführt wird, um Zustandsdaten bezüglich der vorgegebenen Schaltungsanordnung zu ermitteln, und die Zustandsdaten unter Nutzung der Daten zum Ermitteln der prognostizierten Betriebsdauer ausgewertet werden, um die Restbetriebsdauer zu ermitteln. Dadurch kann erreicht werden, dass die Funktionalität der Schaltungsanordnung, die von der Funktionalität des Elektrolytkondensators abhängig sein kann, prognostiziert werden kann. Es ist also nicht nur möglich, die Restbetriebsdauer des Elektrolytkondensators zu ermitteln, sondern es kann darüber hinaus auch ermittelt werden, ab wann mit einer Funktionsstörung der Schaltungsanordnung insgesamt gerechnet werden sollte.

Insbesondere bei aufwändigen Schaltungsanordnungen, beispielsweise aufwendigen, umfangreichen Rechneranlagen und/oder dergleichen kann dies wichtig sein, weil die Möglichkeit besteht, eine entsprechende Wartung im Vorfeld zu planen und vorzubereiten. Dadurch können Ausfallsituationen der Schaltungsanordnung weitgehend vermieden werden, wodurch die Zuverlässigkeit und die Verfügbarkeit der Schaltungsanordnung insgesamt verbessert werden kann. Dies kann natürlich Rechneranlagen betreffen, die eine Vielzahl von Elektrolytkondensatoren umfassen. Aber nicht nur Rechneranlagen können hiervon betroffen sein, sondern auch andere Anlagen, beispielsweise sicherheitstechnische Einrichtungen, medizinische Einrichtungen und/oder dergleichen, bei denen ein Ausfall der Schaltungsanordnung Schaden beziehungsweise gefährliche Zustände verursachen kann.

Die für die erfindungsgemäßen Verfahren angegebenen Vorteile und Wirkungen gelten natürlich gleichermaßen für die entsprechenden Einrichtungen der Erfindung und umgekehrt. Insofern können für Verfahrensmerkmale natürlich auch Vorrichtungsmerkmale und umgekehrt formuliert sein.

Weitere Vorteile und Merkmale ergeben sich durch die folgende Beschreibung von Ausführungsbeispielen anhand der Figuren. In den FIG bezeichnen gleiche Bezugszeichen gleiche Merkmale und Funktionen. Es zeigen:
- FIG 1: in einer schematischen Diagrammdarstellung eine relative Änderung einer elektrischen Kapazität eines Elektrolytkondensators abhängig von einer Betriebsdauer;
- FIG 2: eine schematische Diagrammdarstellung wie in FIG 1, bei der mit einem Graphen eine Änderung einer Impedanz des Elektrolytkondensators abhängig von der Betriebsdauer dargestellt ist;
- FIG 3: eine schematische Diagrammdarstellung wie in FIG 1, bei der für den Elektrolytkondensator mittels eines Graphen eine Änderung eines Verlustfaktors des Elektrolytkondensators abhängig von der Betriebsdauer dargestellt ist;
- FIG 4: eine schematische Diagrammdarstellung wie in FIG 1, bei der mittels eines Graphen eine Änderung eines Reststroms des Elektrolytkondensators abhängig von der Betriebsdauer dargestellt ist;
- FIG 5: eine schematische Diagrammdarstellung einer erfassten elektrischen Spannung eines Elektrolytkondensators, der in einer Schaltungsanordnung angeschlossen ist und der zum Stützen einer Betriebsgleichspannung während des bestimmungsgemäßen Betriebs in der Schaltungsanordnung dient, wobei der Elektrolytkondensator seine Bemessungskapazität als aktuelle elektrische Kapazität bereitstellt, wobei mit einem Graphen die elektrische Spannung am Elektrolytkondensator dargestellt ist; und
- FIG 6: eine schematische Diagrammdarstellung wie in FIG 5, bei der nun jedoch der Elektrolytkondensator nur noch 25% der Bemessungskapazität als aktuelle elektrische Kapazität zur Verfügung stellt.

Bei Elektrolytkondensatoren ist die Verdunstung eines Elektrolyten und eine damit verbundene Diffusion von Gasen, die aus dem Elektrolytkondensator entweichen, temperaturabhängig. Lebensdauerprüfungen von Herstellern werden in der Regel bei einer oberen Grenztemperatur beziehungsweise Betriebstemperatur durchgeführt. Ein Betrieb des Elektrolytkondensators bei einer geringeren Temperatur führt aber zu einer geringeren Diffusionsrate des Elektrolyten, sodass eine längere Betriebsdauer verfügbar ist. Die damit verbundene Verlängerung der Betriebsdauer wird in vielen Datenblättern von Herstellern meist durch die sogenannte 10-Grad-Regel beschrieben, nach der eine Verdoppelung der Betriebsdauer bei einer Temperaturreduzierung um 10°C die Folge ist. Hierbei werden allerdings Spannungsabhängigkeiten nicht berücksichtigt.

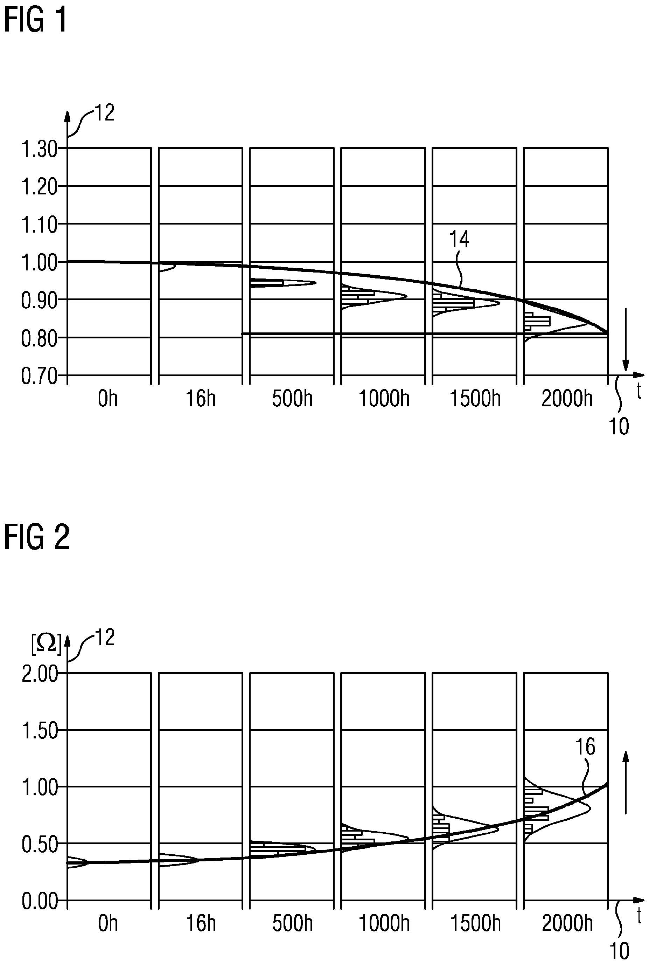

FIG 1 zeigt in einer schematischen Diagrammdarstellung mit einem Graphen 14 eine relative Änderung einer elektrischen Kapazität eines Elektrolytkondensators über der Zeit in Stunden. Eine Abszisse 10 ist hier der Zeit t in Stunden zugeordnet, wohingegen eine Ordinate 12 der relativen normierten Änderung der elektrischen Kapazität zugeordnet ist.

Wie der Graph 14 zeigt, nimmt die Kapazität des Elektrolytkondensators mit zunehmender Betriebsdauer deutlich ab. Bereits nach etwa 1500 Betriebsstunden beträgt die elektrische Kapazität des Elektrolytkondensators lediglich noch 90% der Bemessungskapazität zu Beginn der Betriebsaufnahme.

Für den Elektrolytkondensator, der der Diagrammdarstellung gemäß FIG 1 zugrunde liegt, zeigt FIG 2 in einem vergleichbaren schematischen Diagramm die Änderung seiner Impedanz. Die Abszisse 10 ist hier wieder der Zeit t in Stunden zugeordnet, wohingegen die Ordinate 12 dieses Mal dem elektrischen Wiederstand des Kondensators in Ω zugeordnet ist. Zu erkennen ist, dass die Impedanz des Elektrolytkondensators nach etwa 1500 Stunden sich auf etwa 0,7Ω nahezu verdoppelt hat. Nach weiteren 500 Betriebsstunden beträgt die Impedanz sogar etwa 1Ω, wie anhand des Graphen 16 in FIG 1 ersichtlich ist. Mit zunehmender Betriebsdauer steigt also die Impedanz des Elektrolytkondensators an.

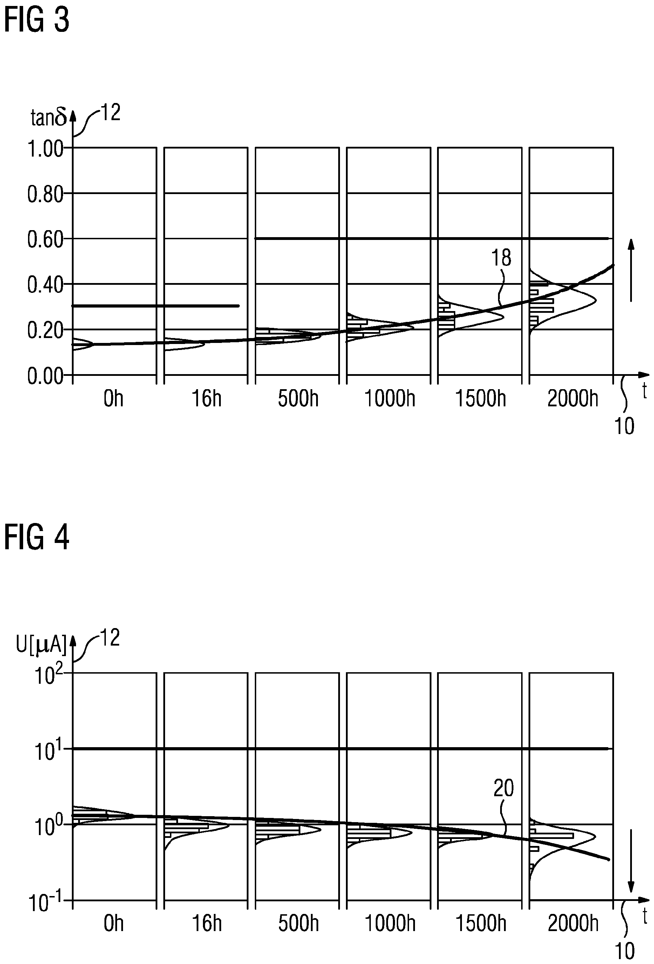

FIG 3 zeigt in einer weiteren schematischen Diagrammdarstellung wie FIG 1, für den Elektrolytkondensator die Änderung eines Verlustfaktors beziehungsweise eines ESR gegenüber der Betriebsdauer in Stunden. Die Abszisse 10 ist hier ebenfalls wieder der Zeit t in Stunden zugeordnet, wohingegen die Ordinate 12 dem Verlustfaktor tanδ zugeordnet ist. Wie aus FIG 3 anhand des Graphen 18 ersichtlich ist, steigt der Verlustfaktor mit zunehmender Betriebsdauer deutlich an. Zu Beginn seiner Betriebsdauer liegt der Verlustfaktor bei etwa 0,15. Nach 1500 Betriebsstunden hat der Verlustfaktor bereits einen Wert von etwa 0,3 erreicht. Nach 2000 Betriebsstunden liegt er bei etwa 0,5.

FIG 4 zeigt für den Elektrolytkondensator eine schematische Diagrammdarstellung wie FIG 1, bei der nun jedoch eine Änderung eines Reststroms beziehungsweise eines Leckstroms des Elektrolytkondensators über der Betriebsdauer dargestellt ist. Die Abszisse 10 ist hier ebenfalls wieder der Zeit t in Stunden zugeordnet, wohingegen die Ordinate 12 hier dem Leckstrom in µA zugeordnet ist. Ersichtlich ist anhand eines Graphen 20, dass der Leckstrom zu Beginn etwa 1µA beträgt und mit zunehmender Betriebsdauer abnimmt. Dabei ist der logarithmische Maßstab der Ordinate zu beachten. Der Leckstrom nimmt also deutlich mit zunehmender Betriebsdauer ab.

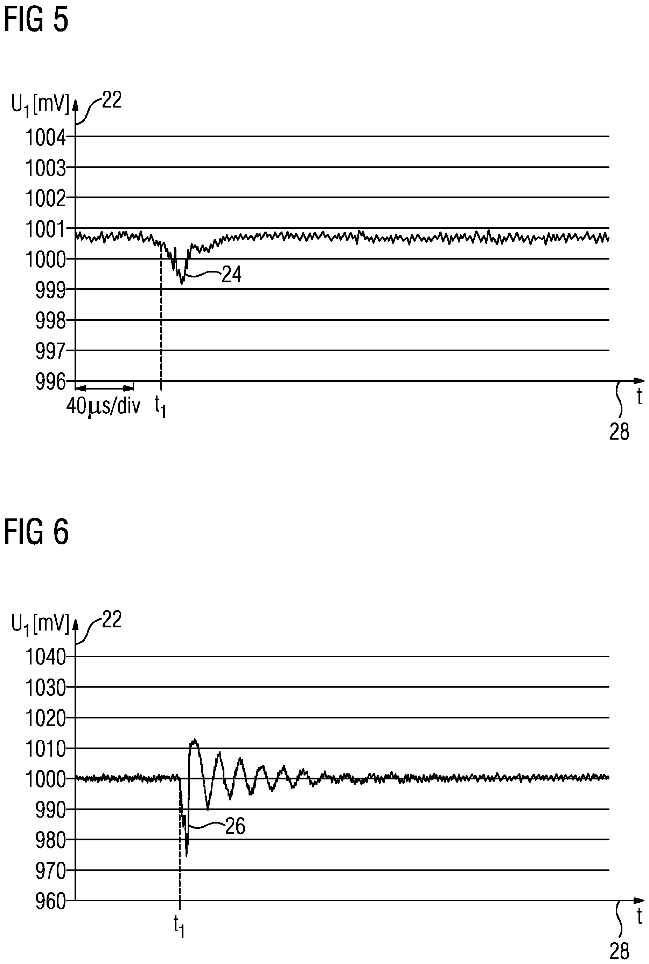

FIG 5 zeigt nun die Anwendung des Verfahrens zum Ermitteln der Funktionalität eines in einer Schaltungsanordnung angeschlossenen Elektrolytkondensators, dessen Eigenschaften anhand der FIG 1 bis 4 erläutert wurden und der zum Stützen einer Betriebsgleichspannung während eines bestimmungsgemäßen Betriebs in der Schaltungsanordnung dient. Vorliegend ist die Schaltungsanordnung durch eine Rechnereinheit gebildet, hier eine Central Processing Unit (CPU). Der Elektrolytkondensator dient zum Stabilisieren einer Betriebsgleichspannung, die für den bestimmungsgemäßen Betrieb der CPU erforderlich ist. Moderne CPUs werden mit kleinen Betriebsgleichspannungen betrieben, zum Beispiel mit einer Betriebsgleichspannung von etwa 1V. Derartige CPUs benötigen jedoch für den bestimmungsgemäßen Betrieb einen entsprechend großen Strom. Dabei können große Stromsprünge auftreten, beispielsweise in einem Leerlauf ein Betriebsstrom von etwa 1A bis etwa 2A, wobei der Betriebsstrom auf 15A bis etwa 20A in kurzer Zeit ansteigen kann, zum Beispiel innerhalb weniger µs.

Um eine entsprechende Betriebsgleichspannungsquelle hinsichtlich ihrer Funktionalität in Bezug auf die Stabilisierung der Betriebsgleichspannung prüfen zu können, beispielsweise im Rahmen einer Reparatur oder dergleichen, kann ein erzwungener Stromsprung auf den Elektrolytkondensator gegeben werden. Dies kann mittels einer separaten Einrichtung erfolgen, die einen entsprechen Prüfstrom als vorgegebenen Strom auf den Elektrolytkondensator aufgibt. Darüber hinaus kann natürlich auch die CPU so gesteuert werden, dass sie den Elektrolytkondensator mit einem entsprechenden Strom belastet.

FIG 5 zeigt in einer schematischen Diagrammdarstellung mit einem Graphen 24 eine erfasste elektrische Spannung an dem Elektrolytkondensator, die mittels eines geeigneten Spannungssensors erfasst wird. Der Elektrolytkondensator ist in der Schaltungsanordnung angeschlossen, die die vorgenannte CPU umfasst, und er dient dem Stützen der Betriebsgleichspannung während des bestimmungsgemäßen Betriebs in der Schaltungsanordnung.

Eine Abszisse 28 des Diagramms in FIG 5 ist der Zeit t zugeordnet, wobei ein Zeitabschnitt etwa 40µs/div entspricht. Eine Ordinate 22 ist der erfassten elektrischen Spannung U₁ in der Einheit mV zugeordnet. Der Graph 24 stellt die erfasste elektrische Spannung U₁ dar, und zwar für den Elektrolytkondensator zu Beginn seines bestimmungsgemäßen Betriebs, bei dem er etwa 100% seiner Bemessungskapazität als aktuelle Kapazität zur Verfügung stellt.

Aus dem Diagramm ist ersichtlich, dass der Elektrolytkondensator zu einem Zeitpunkt t₁ mit einem vorgegebenen Strom nach Art eines Impulses aufgrund der Beanspruchung durch die CPU beaufschlagt wird. Zu erkennen ist, dass eine nominale Betriebsgleichspannung von etwa 1000mV, das heißt, etwa 1V vorliegt. Zu dem Zeitpunkt t₁ bricht diese Spannung um etwa 1mV ein. Ein derartiger Spannungseinbruch kann von der CPU gut verkraftet werden, sodass der bestimmungsgemäße Betrieb der Schaltungsanordnung durch diesen Spannungseinbruch nicht beeinträchtigt wird. Eine übergeordnete Regelung einer Betriebsgleichspannungsquelle, hier ein DC/DC-Wandler, regelt den erhöhten Energieverbrauch der CPU, der zum Zeitpunkt t₁ auftritt, etwa aus. Bis die Regelung sich auf den erhöhten Stromverbrauch, der durch den Stromsprung als vorgegebener Strom der CPU verursacht ist, reagiert, kann der Elektrolytkondensator der Stromsprung abfangen und den Spannungseinbruch auf etwa 1mV begrenzen.

FIG 6 zeigt nun eine schematische Diagrammdarstellung wie FIG 5, bei der nun jedoch mittels eines Graphen 26 die Situation dargestellt ist, bei der der Elektrolytkondensator aufgrund seiner Alterung nur noch etwa 25% seiner Bemessungskapazität als aktuelle elektrische Kapazität zur Verfügung zu stellen vermag. Zum Zeitpunkt t₁ erfolgt wieder die Beaufschlagung des Elektrolytkondensators mittels des Stromsprungs, wie bereits zur FIG 5 erläutert. Der Stromsprung hat etwa denselben Wert. Die Abszisse und die Ordinate sind wiederum der Zeit t und der erfassten elektrischen Spannung U₁ zugeordnet, wie bereits ebenfalls zur FIG 5 erläutert. Die Skalierung der Ordinate ist hier jedoch um einen Faktor 10 verändert, um die Verhältnisse mittels des Graphen 26 in einem vergleichbaren Diagramm darstellen zu können.

Aus FIG 6 ist anhand des Graphen 26 ersichtlich, dass zum Zeitpunkt t₁ aufgrund des Stromsprungs ein Spannungseinbruch von etwa 20mV erfolgt. Der Spannungseinbruch ist dem Grunde nach bereits also um den Faktor 20 größer als der in der in FIG 5 dargestellten Situation. Darüber hinaus zeigt sich nun eine Schwingung der erfassten elektrischen Spannung U₁, die sich weit über eine ms erstreckt. Dies ist eine Folge des starken Spannungseinbruchs, der durch die Regelung des DC/DC-Wandlers ausgeglichen werden soll. Die Reglereigenschaften des DC/DC-Wandlers verursachen die Schwingung, die vorliegend eine gedämpfte Schwingung ist. Aufgrund der geringen Kapazität des Elektrolytkondensators gegenüber der Situation wie sie anhand von FIG 5 erläutert wurde, ist hier also nicht nur ein erhöhter Spannungseinbruch zu verzeichnen, sondern die Betriebsgleichspannung wird zu einer Schwingung angeregt. Dies kann zu einer Funktionsstörung der Schaltungsanordnung, insbesondere der CPU führen, sodass der bestimmungsgemäße Betrieb der Schaltungsanordnung beziehungsweise der CPU beeinträchtigt sein kann. In dieser Situation ist daher zu empfehlen, den Elektrolytkondensator auszutauschen.

Die erfasste elektrische Spannung U₁ wird also ausgewertet, indem sie zum Beispiel mit einem vorgegeben Spannungsvergleichswert für einen Spannungseinbruch verglichen wird. Im vorliegenden Fall kann vorgesehen sein, dass der Spannungseinbruch 2mV nicht überschreiten soll. Bei einer nominalen Betriebsgleichspannung von etwa 1V kann der Spannungsvergleichswert somit bei 998mV gewählt sein. Wird ein größerer Spannungseinbruch als etwa 2mV ermittelt, kann hieraus ein Meldesignal abgeleitet werden.

Darüber hinaus kann das Auswerten auch das Auftreten einer Schwingneigung umfassen. Zu diesem Zweck kann die erfasste elektrische Spannung U₁ hinsichtlich dem Auftreten von Schwingungen untersucht werden, beispielsweise mittels einer Fourier Transformation und/oder dergleichen. Treten Schwingungsamplituden in vorgegebenen Frequenzbereichen auf, kann dies ebenfalls zum Auslösen eines Meldesignals führen.

Darüber hinaus kann aus der erfassten elektrischen Spannung unter Zuhilfenahme statistischer Auswertemethoden ein Kapazitätsverlust des Elektrolytkondensators ermittelt werden. Dieser Kapazitätsverlust kann als Meldesignal ausgegeben werden.

Die unterschiedlichen Methoden können ferner in nahezu beliebiger Weise miteinander kombiniert sein.

Darüber hinaus erlaubt es die Erfindung, eine Vielzahl gleichartiger Baugruppen auszuwerten und hierdurch zuverlässige statistische Aussagen über eine prognostizierte Betriebsdauer des Elektrolytkondensators zu erhalten. Anhand der erfassten elektrischen Spannung kann dann ermittelt werden, wann die Funktionalität des Elektrolytkondensators nicht mehr für den bestimmungsgemäßen Betrieb der Schaltungsanordnung ausreicht.

Insgesamt erlaubt es die Erfindung also, ohne direkte Kapazitätsmessung der Kondensatoren und ohne einen Ausbau der Kondensatoren zur Messung vornehmen zu müssen, die Alterung der Kondensatoren anhand einer Lastwechselmessung zu ermitteln und eine Einschätzung der Restkapazität des Elektrolytkondensators vorzunehmen, damit auch eine Aussage zur Notwendigkeit eines Wechsels beziehungsweise einer Wartung des Elektrolytkondensators getroffen werden kann. Es kann daher vergleichsweise genau festgestellt werden, ab wann die Betriebsgleichspannung aufgrund des Kapazitätsverlusts des Elektrolytkondensators ein problematisches Verhalten für die Schaltungsanordnung zeigt, beispielsweise das Auftreten einer Schwingung der Betriebsgleichspannung bei einem Lastsprung oder dergleichen.

Die Ausführungsbeispiele dienen ausschließlich der Erläuterung der Erfindung und für diese nicht beschränkend.

## Patentansprüche

1. Verfahren zum Ermitteln einer Funktionalität eines in einer Schaltungsanordnung angeschlossenen Elektrolytkondensators, der zum Stützen einer Betriebsgleichspannung während eines bestimmungsgemäßen Betriebs in der Schaltungsanordnung dient, bei dem:
- der Elektrolytkondensator in der Schaltungsanordnung mit einem vorgegebenen Strom beaufschlagt wird,
- eine elektrische Spannung (U₁) am Elektrolytkondensator erfasst wird, und
- die erfasste elektrische Spannung (U₁) zum Ermitteln der Funktionalität des Elektrolytkondensators ausgewertet wird.

2. Verfahren nach Anspruch 1,
**dadurch gekennzeichnet, dass**
das Auswerten ein Ermitteln eines Auftretens oder eines Verstärkens wenigstens eines Schwingereignisses bei der erfassten elektrischen Spannung umfasst.

3. Verfahren nach Anspruch 1 oder 2,
**dadurch gekennzeichnet, dass**
das Auswerten ein Ermitteln einer Anzahl der Schwingereignisse umfasst.

4. Verfahren nach Anspruch 2 oder 3,
**dadurch gekennzeichnet, dass**
das Auswerten ein Ermitteln einer Zeitdauer des wenigstens eines Schwingereignisses umfasst.

5. Verfahren nach einem der vorhergehenden Ansprüche,
**dadurch gekennzeichnet, dass**
der Elektrolytkondensator mit einem Stromsprung oder einem Stromimpuls als vorgegebenen Strom beaufschlagt wird.

6. Verfahren nach einem der vorhergehenden Ansprüche,
**dadurch gekennzeichnet, dass**
die Schaltungsanordnung zum Beaufschlagen des Elektrolytkondensators mit dem vorgegebenen Strom in geeigneter Weise gesteuert wird.

7. Verfahren nach einem der vorhergehenden Ansprüche,
**dadurch gekennzeichnet, dass**
zum Auswerten ein Vergrößern eines Rippels der erfassten elektrischen Spannung (U₁) berücksichtigt wird.

8. Verfahren nach einem der vorhergehenden Ansprüche,
**dadurch gekennzeichnet, dass**
abhängig von dem Auswerten eine aktuelle Kapazität des Elektrolytkondensators ermittelt wird.

9. Verfahren nach einem der vorhergehenden Ansprüche,
**dadurch gekennzeichnet, dass**
der vorgegebene Strom mittels eines Stromsensors erfasst wird und das Auswerten ergänzend den erfassten Prüfstrom berücksichtigt.

10. Verfahren nach einem der vorhergehenden Ansprüche,
**dadurch gekennzeichnet, dass**
das Auswerten durch das Beaufschlagen des Elektrolytkondensators mit dem vorgegebenen Strom ausgelöst wird.

11. Verfahren zum Prognostizieren einer Betriebsdauer eines in einer Schaltungsanordnung angeschlossenen Elektrolytkondensators, der zum Stützen einer Betriebsgleichspannung während eines bestimmungsgemäßen Betriebs in der Schaltungsanordnung dient, bei dem:
- für eine Mehrzahl von gleichartigen Schaltungsanordnungen jeweils das Verfahren nach einem der vorhergehenden Ansprüche durchgeführt wird, und
- die mit dem Verfahren nach den vorhergehenden Ansprüchen ermittelten Daten zum Ermitteln der prognostizierten Betriebsdauer statistisch ausgewertet werden.

12. Verfahren nach Anspruch 11,
**dadurch gekennzeichnet, dass**
für einen in einer vorgegebenen Schaltungsanordnung angeschlossenen Elektrolytkondensator eine Restbetriebsdauer ermittelt wird, indem:
- für die vorgegebene Schaltungsanordnung das Verfahren nach einem der Ansprüche 1 bis 10 durchgeführt wird, um Zustandsdaten bezüglich der vorgegebenen Schaltungsanordnung zu ermitteln, und
- die Zustandsdaten unter Nutzung der Daten zum Ermitteln der prognostizierten Betriebsdauer ausgewertet werden, um die Restbetriebsdauer zu ermitteln.

13. Einrichtung zum Ermitteln einer Funktionalität eines in einer Schaltungsanordnung angeschlossenen Elektrolytkondensators, der zum Stützen einer Betriebsgleichspannung während eines bestimmungsgemäßen Betriebs in der Schaltungsanordnung dient, wobei die Einrichtung ausgebildet ist:
- das Beaufschlagen des Elektrolytkondensators mit einem Prüfstrom in der Schaltungsanordnung zu erfassen,
- eine elektrische Spannung (U₁) am Elektrolytkondensator zu erfassen, und
- die erfasste elektrische Spannung (U₁) zum Ermitteln der Funktionalität des Elektrolytkondensators auszuwerten.

14. Einrichtung nach Anspruch 13,
**dadurch gekennzeichnet, dass**
die Einrichtung als Spannungsversorgungseinrichtung, als Spannungswandler oder als digitale Hardwareschaltung, insbesondere nach Art eines Motherboards ausgebildet ist.

15. Prognoseeinrichtung zum Prognostizieren einer Betriebsdauer eines in einer Schaltungsanordnung angeschlossenen Elektrolytkondensators, der zum Stützen einer Betriebsgleichspannung während eines bestimmungsgemäßen Betriebs in der Schaltungsanordnung dient, wobei die Einrichtung ausgebildet ist:
- mittels einer Einrichtung nach Anspruch 13 für eine Mehrzahl von gleichartigen Schaltungsanordnungen jeweils eine Funktionalität eines in den jeweiligen Schaltungsanordnungen angeschlossenen Elektrolytkondensators zu ermitteln, und
- die mit der Einrichtung nach Anspruch 13 ermittelten Daten zum Ermitteln der prognostizierten Betriebsdauer statistisch auszuwerten.
